# EUROPÄISCHE PATENTSCHRIFT

(11) **EP 3 605 762 B1**
(45) Veröffentlichungstag und Bekanntmachung des Hinweises auf die Patenterteilung: **10.11.2021**
(21) Anmeldenummer: 19187788.5
(22) Anmeldetag: 23.07.2019
(51) Int. Cl.: H02G 5/10, H02M 7/00, B60L 15/00, H05K 1/02, B60R 16/02

(54) **ANORDNUNG MIT EINER STROMSCHIENENVORRICHTUNG UND EINEM STROMRICHTERGEHÄUSE SOWIE VERFAHREN ZU DEREN HERSTELLUNG, STROMRICHTER FÜR EIN FAHRZEUG UND FAHRZEUG**
ARRANGEMENT COMPRISING A BUSBAR DEVICE AND A CONVERTER HOUSING AND METHOD FOR THE PRODUCTION THEREOF, VEHICLE AND POWER CONVERTER FOR A VEHICLE
AGENCEMENT DOTÉ D'UN DISPOSITIF DE RAIL CONDUCTEUR ET D'UN LOGEMENT DE CONVERTISSEUR DE COURANT AINSI QUE SON PROCÉDÉ DE FABRICATION, CONVERTISSEUR DE COURANT POUR UN VÉHICULE ET VÉHICULE

(30) Priorität: 31.07.2018 DE 102018118525
(43) Veröffentlichungstag der Anmeldung: 05.02.2020
(73) Patentinhaber: Valeo Siemens eAutomotive Germany GmbH, 91056 Erlangen (DE)
(72) Erfinder: SCHMITT, Matthias, 91126 Schwabach (DE); KOURGIALIS, Alexandros, 95195 Röslau (DE); KAISER, Anna, 90402 Nürnberg (DE); ALEXANDRU, Andrei, 90768 Fürth (DE); HOYLER, Christoph, 91241 Kirchensittenbach (DE); NOBEL, Michael, 90425 Nürnberg (DE)
(74) Vertreter: Dr. Gassner & Partner mbB

(56) Entgegenhaltungen:
- WO-A1-2013/136877
- WO-A1-2017/187598
- US-A1- 2010 302 733
- US-A1- 2014 116 751

## Beschreibung

Anordnung mit einer Stromschienenvorrichtung und einem Stromrichtergehäuse sowie Verfahren zu deren Herstellung, Stromrichter für ein Fahrzeug und Fahrzeug

Die vorliegende Erfindung betrifft eine Anordnung mit einer Stromschienenvorrichtung und einem Stromrichtergehäuse, wobei die Stromschienenvorrichtung einen Stapel aus wenigstens zwei Stromschienen und einen elektrisch isolierenden Isolationskörper, der die Stromschienen in zwei Isolationsbereichen der Stromschienenvorrichtung einschließt, aufweist, wobei jede Stromschiene zwei gegenüberliegende, sich in Stromflussrichtung erstreckende Grundflächen und die Grundflächen verbindende, sich in Stromflussrichtung erstreckende Seitenflächen aufweist. Daneben betrifft die Erfindung ein Verfahren zur Herstellung einer solchen Anordnung sowie einen Stromrichter für ein Fahrzeug und ein Fahrzeug.

Die US 2010/302733 A1 offenbart eine Stromschienenanordnung mit mehreren Stromschienen. Zwei Stromschienen sind in einem Stapel mit einer weiteren Stromschiene dazwischen angeordnet. Ein isolierendes Material ist in Lücken zwischen des Stromschienen eingespritzt. Wenigstens eine Stromschiene weist eine Vielzahl von durchgängigen Kanälen auf, durch welche eine Kühlflüssigkeit fließen kann und die durch eine Dichtungsplatte verschlossen sind. Enden der Kanäle kommunizieren mit Verteilern an Enden der Stromschienenanordnung. Die WO 2017/187598 A1 offenbart einen fahrzeugmontierten Stromrichter mit Stromschienen, die die Wärme außerhalb des Gehäuses abführt, wobei das Gehäuse als Wärmesenke verwendet wird.

Stromschienenvorrichtungen für Stromrichter dienen dem Transport hoher Ströme und weisen häufig einen elektrisch isolierenden Isolationskörper auf, der durch Umspritzen von zu einem Stapel angeordneten Stromschienen ausgebildet ist. Die Stromschienenvorrichtung wird typischerweise an einem Stromrichtergehäuse befestigt. Während des Betriebs erwärmen sich die Stromschienen durch den sie durchfließenden elektrischen Strom. Die Wärmeabfuhr aus solchen Stromschienenvorrichtungen ist jedoch aufgrund des hohen Wärmeübertragungswiderstands des Isolationskörpers unbefriedigend. Es sind daher entsprechend hohe Leitungsquerschnitte der Stromschienen erforderlich, was jedoch wegen den Anforderungen an einen bauraum- und gewichtssparenden Aufbau im Bereich der Elektromobilität unerwünscht ist.

Es wurde bereits vorgeschlagen, pulverbeschichtete Stromschienen zu verwenden, die direkt an gut wärmeleitenden Metallteilen des Stromrichtergehäuses befestigt werden. Die Herstellung derartiger pulverbeschichteter Stromschienen ist jedoch teuer und erlaubt nicht die Ausbildung von Verbindungselementen, wie sie an einem im Spritzgussverfahren ausgebildeten Isolationskörper vorgesehen sein können, um beispielsweise zusätzliche Komponenten an der Stromschienenvorrichtung anzuordnen.

Der Erfindung liegt mithin die Aufgabe zugrunde, eine demgegenüber verbesserte Möglichkeit zur Wärmeabfuhr aus einer Stromschienenvorrichtung anzugeben.

Zur Lösung dieser Aufgabe ist erfindungsgemäß eine Anordnung gemäß Anspruch 1 vorgesehen.

Die Erfindung beruht auf der Überlegung, im Isolationskörper der Stromschienenvorrichtung die Öffnung auszubilden, sodass die Stromschienen im Temperierbereich nicht vollständig vom Isolationskörper bedeckt sind. Diese freiliegenden bzw. nicht bedeckten Teile der Stromschiene können dann über das, zweckmäßigerweise elektrisch isolierendende, Wärmeübertragungsmittel mit dem Stromrichtergehäuse gekoppelt werden. So wird eine Wärmeübertragung über den einen verhältnismäßig hohen Wärmeübertragungswiderstand aufweisenden Isolationskörper vermieden und stattdessen der wesentlich geringere Wärmeübertragungswiderstand des Wärmeübertragungsmittels genutzt.

Bei der erfindungsgemäßen Anordnung können somit vorteilhafterweise Stromschienenvorrichtungen verwendet werden, die bei gleicher Stromtragfähigkeit einen geringeren Leitungsquerschnitt aufweisen als herkömmliche Stromschienenvorrichtungen und dementsprechend gewichtsparender und kostengünstiger herstellbar sind. Gleichsam ist die Stromschienenvorrichtung der erfindungsgemäßen Anordnung auch bauraumsparender als eine herkömmliche Stromschienenvorrichtung. Vorteilhafterweise werden zur Realisierung der verbesserten Kühlfähigkeit bei der erfindungsgemäßen Anordnung über das leicht verfügbare Wärmeübertragungsmittel hinaus keine zusätzlichen Komponenten benötigt.

Die Stromschienen umfassen typischerweise einen Kern aus Kupfer, der zusätzlich mit einer Metallschicht überzogen sein kann. Das Stromrichtergehäuse ist bevorzugt zumindest in dem mit dem Wärmeübertragungsmittel in Verbindung stehenden Bereich aus Aluminium gebildet. Das Stromrichtergehäuse kann ein Druckgussgehäuse sein. Bevorzugt weist das Stromrichtergehäuse eine aktive Kühlung, insbesondere eine Flüssigkeitskühlung, auf, um die Stromschienen effizient zu entwärmen. Der Stapel kann auch drei oder mehr Stromschienen umfassen. Die Stromschienen sind typischerweise derart angeordnet, dass ihre Grundflächen übereinanderliegen. Die Grundflächen weisen typischerweise einen größeren Flächeninhalt auf als die Seitenflächen. Im Temperierbereich bedeckt der Isolationskörper typischerweise die andere, also nicht die mit dem Wärmeübertragungsmittel in Berührung stehende Seitenflächen und Teile beider Grundflächen. Im Temperierbereich kann auch eine Grundfläche vollständig durch den Isolationskörper bedeckt sind, sofern die andere Grundfläche teilweise freiliegt.

Es ist bei der erfindungsgemäßen Anordnung von besonderem Vorteil, wenn der Isolationskörper im Temperierbereich zwischen jedem Paar benachbarter Stromschienen einen Vorsprung aufweist, der sich entlang der Grundflächen über die freiliegende Seitenfläche hinaus erstreckt. Mit anderen Worten ragt der Vorsprung weiter in das Wärmeübertragungsmittel hinein, als die einzelnen Stromschienen. Der Vorsprung erlaubt eine Vergrößerung der Kriechstrecken zwischen den Stromschienen und erhöht so die elektrische Sicherheit der Anordnung.

Mit besonderem Vorteil kann ferner bei der erfindungsgemäßen Anordnung vorgesehen sein, dass der Isolationskörper im Isolationsbereich einen Abstandshalter aufweist, der auf dem Stromrichtergehäuse aufliegt und die Stromschienen im Temperierbereich vom Stromrichtergehäuse beabstandet. Der Abstandshalter vergrößert mithin den Abstand zwischen den Stromschienen und dem Stromrichtergehäuse, sodass ein größerer durch das Wärmeübertragungsmittel gefüllter Raum zwischen den Stromschienen und dem Stromrichtergehäuse ausgebildet wird. Dies vergrößert vorteilhafterweise die Durchschlagsspannung zwischen den Stromschienen und dem Stromrichtergehäuse.

Alternativ oder zusätzlich kann zur Vergrößerung des Abstands zwischen dem Stromrichtergehäuse und den Stromschienen vorgesehen sein, dass das Stromrichtergehäuse eine das Wärmeübertragungsmittel aufnehmende Eintiefung aufweist.

Erfindungsgemäß ist das Wärmeübertragungsmittel ein Gapfiller. Dieser zeichnet sich durch einen geringen Wärmeübertragungswiderstand und eine leichte Verarbeitbarkeit aus. Die Stromschienen sind erfindungsgemäß im Temperierbereich in den Gapfiller eingetaucht, sodass dieser gleichzeitig die thermische Anbindung und die elektrische Isolierung zum Stromrichtergehäuse realisiert. Dies ermöglicht insbesondere eine besonders einfache, automatisierbare Fertigung der Anordnung.

Grundsätzlich wird es bevorzugt, wenn die Anordnung mehrere, jeweils durch einen Isolationsbereich getrennte Temperierbereiche aufweist. So kann die Stromschienenvorrichtung einen durch einen weiteren Isolationsbereich vom ersten Isolationsbereich getrennten weiteren Temperierbereich aufweisen, wobei die Stromschienen im weiteren Isolationsbereich, insbesondere um 90°, abgewinkelt verlaufen. Derartige abgewinkelte Abschnitte von Stromschienenvorrichtungen können zur Anpassung an die Form einer Gehäuseecke des Stromrichtergehäuses bestimmt sein.

Außerdem kann bei der erfindungsgemäßen Anordnung vorgesehen sein, dass ein durch einen weiteren Isolationsbereich vom ersten Isolationsbereich getrennter weiterer Temperierbereich vorgesehen ist, wobei der Stapel im weiteren Temperierbereich ein weitere Stromschiene aufweist, die im ersten Temperierbereich vom Isolationskörper eingefasst ist und/oder nicht durch das Wärmeübertragungsmittel thermisch an das Stromrichtergehäuse angebunden ist. Bereiche in denen der Stapel wie zuvor beschrieben abschnittsweise eine unterschiedliche Anzahl von Stromschiene aufweist sind insbesondere solche, an denen die einzelnen Stromschienen, beispielsweise mit Leistungshalbleitern, kontaktiert werden. Durch eine entsprechende Ausgestaltung des Isolationskörpers kann auch in diesen Bereichen eine effiziente Entwärmung realisiert werden.

Daneben betrifft die Erfindung ein Verfahren zur Herstellung einer Anordnung mit einer Stromschienenvorrichtung und einem Stromrichtergehäuse gemäß Anspruch 7.

Bevorzugt ist das Wärmeübertragungsmittel ein flüssiges Wärmeübertragungsmittel, wobei der Begriff "flüssig" auch zähflüssige Wärmeübertragungsmittel, insbesondere Suspensionen, umfasst. Bevorzugt wird die Stromschienenvorrichtung vor oder nach dem Aufbringen des Wärmeübertragungsmittels am Stromrichtergehäuse befestigt. Dazu kann ein am Isolationskörper ausgebildetes Befestigungsmittel, insbesondere eine Lasche mit einem Durchgangsloch, verwendet werden.

Besonders bevorzugt erfolgen die Schritte des Aufbringens des Wärmeübertragungsmittels und/oder des Einbringens der Stromschiene in das Wärmeübertragungsmittel und/oder des Befestigens der Stromschienenvorrichtung am Stromrichtergehäuse automatisiert, beispielsweise mittels eines Roboters. Ferner kann der Schritt des Bereitstellens der Stromschienen das Umspritzen der Stromschienen mit einem plastifizierten Kunststoff, insbesondere einem Thermoplast, derart, dass der Isolationskörper mit den Isolationsbereichen und dem Temperierbereich ausgebildet wird, umfassen.

Daneben betrifft die Erfindung einen Stromrichter für ein Fahrzeug, umfassend eine erfindungsgemäße oder durch das erfindungsgemäße Verfahren erhältliche Anordnung und eine im Stromrichtergehäuse aufgenommene Leistungseinheit. Der Stromrichter ist bevorzugt als Wechselrichter ausgebildet.

Außerdem betrifft die Erfindung ein Fahrzeug, umfassend eine elektrische Maschine, die zum Antreiben des Fahrzeugs eingerichtet ist, und einen erfindungsgemäßen Stromrichter, der zum Bereitstellen eines Wechselstroms für die elektrische Maschine eingerichtet ist.

Sämtliche Ausführungen zur erfindungsgemäßen Anordnung lassen sich analog auf den erfindungsgemäßen Stromrichter, das erfindungsgemäße Fahrzeug und das erfindungsgemäße Verfahren übertragen, sodass die zuvor beschriebenen Vorteile auch mit diesen erreicht werden können. Insbesondere können sämtliche zuvor beschriebenen Ausgestaltungen der erfindungsgemäßen Anordnung im Rahmen des erfindungsgemäßen Verfahrens verwendet werden.

Weitere Vorteile und Einzelheiten der vorliegenden Erfindung ergeben sich aus den im folgenden beschriebenen Ausführungsbeispielen sowie anhand der Zeichnungen. Diese sind schematische Darstellungen und zeigen:
- Fig. 1: eine Prinzipskizze eines Ausführungsbeispiels des erfindungsgemäßen Fahrzeugs mit einem Ausführungsbeispiel des erfindungsgemäßen Stromrichters;
- Fig. 2: eine Seitenansicht einer Stromschienenvorrichtung eines Ausführungsbeispiels der erfindungsgemäßen Anordnung;
- Fig. 3: eine Draufsicht der in Fig. 2 gezeigten Stromschienenvorrichtung;
- Fig. 4: eine geschnittene Ansicht der in Fig. 2 gezeigten Stromschienenvorrichtung entlang einer Linie IV-IV in Fig. 3;
- Fig. 5: eine geschnittene Teilansicht der Anordnung entlang einer Linie V-V in Fig. 3;
- Fig. 6: eine Draufsicht auf eine Stromschienenvorrichtung gemäß einem weiteren Ausführungsbeispiel der erfindungsgemäßen Anordnung; und
- Fig. 7: eine perspektivische Teilansicht der in Fig. 6 gezeigten Stromschienenvorrichtung.

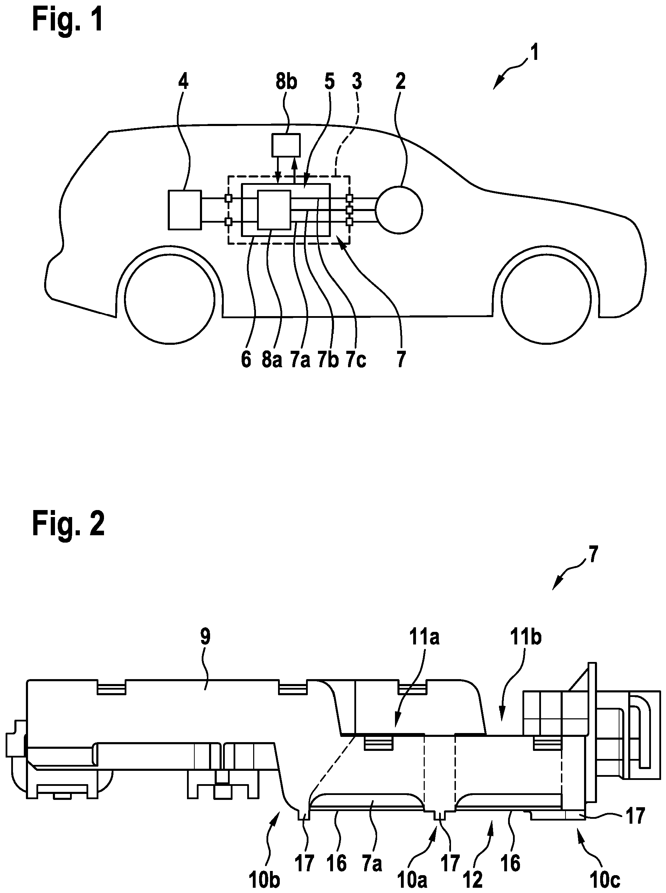

Fig. 1 ist eine Prinzipskizze eines Ausführungsbeispiels eines Fahrzeugs 1, umfassend eine elektrische Maschine 2, die zum Antreiben des Fahrzeugs 1 eingerichtet ist und ein Ausführungsbeispiel eines Stromrichters 3, der zum Bereitstellen eines Wechselstroms für die elektrische Maschine 2 eingerichtet ist.

Der Stromrichter 3 ist als Wechselrichter eingerichtet und dient dazu, eine von einer Hochvoltbatterie 4 bereitgestellte Gleichspannung in einen drei- oder mehrphasigen Wechselstrom zu wandeln. Der Stromrichter 3 umfasst eine Anordnung 5 mit einem Stromrichtergehäuse 6 und eine mehrere Stromschienen 7a, 7b, 7c umfassende Stromschienenvorrichtung 7. Im Stromrichtergehäuse 6 ist ferner eine Leistungseinheit 8a mit mehreren Leistungshalbleiterschaltelementen aufgenommen. Das Stromrichtergehäuse 6 weist Anschlüsse für eine Flüssigkeitskühlung auf, wobei eine Kühleinrichtung 8b des Fahrzeugs 1 an diese angeschlossen ist, die zusätzlich auch zur Kühlung der elektrischen Maschine 2 eingerichtet ist.

Die Anordnung 5 entspricht dabei einem der im Folgenden beschriebenen Ausführungsbeispiele:

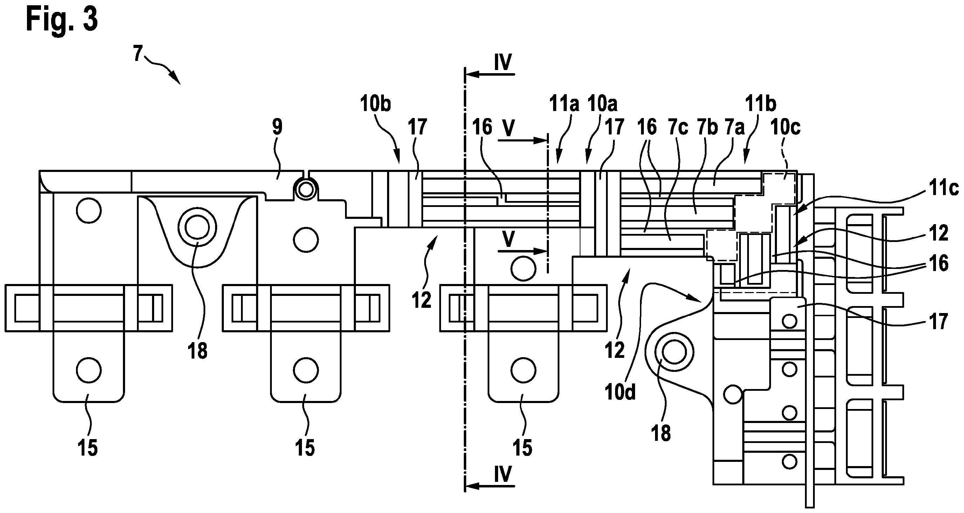

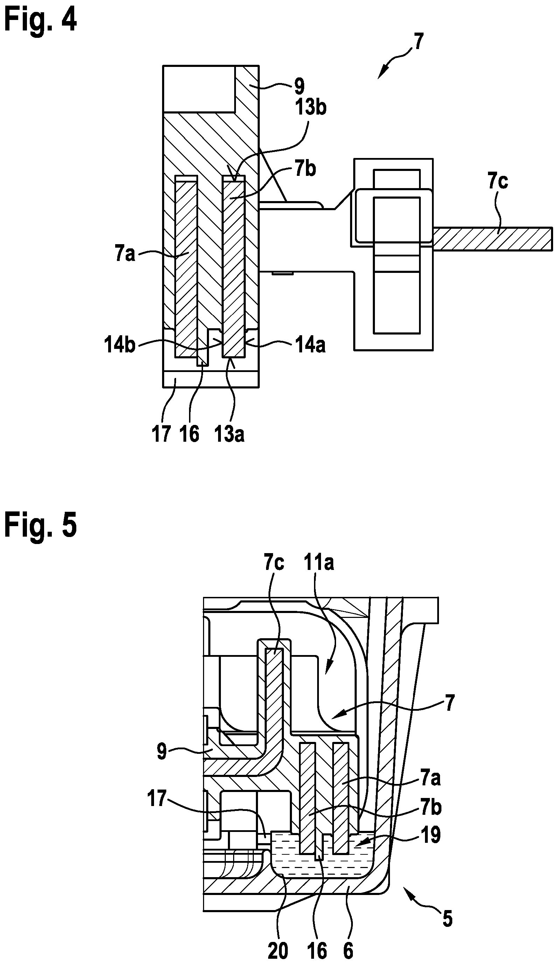

Fig. 2 bis 4 zeigen eine Stromschienenvorrichtung 7 gemäß einem ersten Ausführungsbeispiel der Anordnung 5 (siehe Fig. 5), wobei Fig. 2 eine Seitenansicht, Fig. 3 eine Draufsicht und Fig. 4 eine geschnittene Ansicht entlang einer Linie IV-IV in Fig. 3 ist.

Die Stromschienenvorrichtung 7 umfasst die Stromschienen 7a-7c, von denen in Fig. 2 lediglich die Stromschiene 7a sichtbar ist. Wie aus Fig. 3 ersichtlich ist, bilden die Stromschienen 7a-7c einen Stapel, bei dem sich jeweils die Grundflächen 14a, 14b (siehe Fig. 4) der Stromschienen 7a-7c parallel gegenüberliegen.

Daneben umfasst die Stromschienenvorrichtung 7 einen elektrisch isolierenden Isolationskörper 9, der durch Umspritzen der Stromschienen 7a-7c mit einem Thermoplast gebildet ist. Der Isolationskörper bildet einen ersten Isolationsbereich 10a, einen zweiten Isolationsbereich 10b, einen dritten Isolationsbereich 10c und einen lediglich in Fig. 3 sichtbaren vierten Isolationsbereich 10d aus.

Zwischen einem jeweiligen Paar benachbarter Isolationsbereiche 10a-10d bildet der Isolationskörper 9 Temperierbereiche 11a, 11b sowie einen lediglich in Fig. 3 sichtbaren dritten Temperierbereich 11c aus. Dazu weist der Isolationskörper 9 in jedem Temperierbereich 11a-11c eine Öffnung 12 auf, die eine Seitenfläche 13a (siehe Fig. 4) und einen Teil der Grundflächen 14a, 14b (siehe Fig. 4) einer jeweiligen Stromschiene 7a-7c freilegt. Eine der Seitenflächen 13a gegenüberliegende Seitenfläche 13b und die übrigen Teile der Grundflächen 14a, 14b sind im Temperierbereich 11a-11c vom Isolationskörper 9 eingeschlossen.

Im dritten Isolationsbereich 10c verlaufen die Stromschiene 7a-7c um 90° abgewinkelt. Im ersten Temperierbereich 10a endet zudem die dritte Stromschiene 7c und bildet an ihrem freien Ende einen laschenartigen Anschlussabschnitt 15 zur Kontaktierung der Leistungseinheit 8a aus. Dies erfolgt im zweiten Isolationsbereich 10b ebenfalls nacheinander für die zweite Stromschiene 7b und die erste Stromschiene 7a. Wie insbesondere in Fig. 2 zu erkennen ist, weist der Stapel im zweiten Isolationsbereich 10b einen vertikalen Versprung auf.

Wie der geschnittenen Darstellung in Fig. 4 entnommen werden kann, weist der Isolationskörper im Temperierbereich 11a einen Vorsprung 16 und in den Temperierbereichen 11b, 11c jeweils zwei Vorsprünge 16 auf, die sich zwischen einem jeweiligen Paar benachbarter Stromschienen 7a-7c befinden. Der Vorsprung 16 erstreckt sich entlang der Grundflächen 14a, 14b über die freiliegende Seitenflächen 13a hinaus und liegt jeweils an einer der Stromschienen 7a-7c an.

Wie in Fig. 3 ersichtlich weist der Vorsprung 16 einen mittigen Versprung auf, durch welchen der Vorsprung 16 die Stromschiene 7a-7c, an der er anliegt, wechselt. Dieser Versprung erleichtert die Ausbildung des Vorsprungs 16 beim Spritzgießen, bei dem ein frei zwischen den Stromschienen 7a, 7b stehender Vorsprung 16 nur mit unverhältnismäßigen Aufwand realisierbar wäre.

Darüber hinaus weisen der erste Isolationsbereich 10a, der zweite Isolationsbereich 10b und der vierte Isolationsbereich 10d jeweils einen Abstandshalter 17 auf. Die Abstandshalter 17 sind auf der die Öffnung 12 aufweisenden Seite des Isolationskörpers 9 ausgebildet.

Außerdem weist der Isolationskörper 9 mehrere Befestigungsmittel 18 in Form von abstehenden Laschen mit einem Durchgangsloch auf, um die Stromschienenvorrichtung 7 am Stromrichtergehäuse 6, beispielsweise mittels einer Schraube, zu befestigen.

Fig. 5 ist eine geschnittene Teilansicht der Anordnung 5 entlang einer Linie V-V in Fig. 3, die einen Ausschnitt der Stromschienenvorrichtung 7 in ihrer im Stromrichtergehäuse 6 aufgenommenen Stellung zeigt. In einem jeweiligen Temperierbereich - hier dem ersten Temperierbereich 11a - weist die Anordnung 5 ein Wärmeübertragungsmittel 19 in Form eines flüssig verarbeiteten Gapfillers auf. Dabei ragen die in den Temperierbereichen 11a-11c freiliegenden Abschnitte der Stromschienen 7a, 7b, 7c in das Wärmeübertragungsmittel 19 hinein und sind dadurch thermisch an das Stromrichtergehäuse 6 angebunden.

Der über die erste Seitfläche 13a hinausragende Vorsprung 16 realisiert dabei eine verlängerte Kriechstrecke zwischen den Stromschienen 7a-7c. Der Abstandhalter 17 sorgt für einen vergrößerten Abstand zwischen den Stromschiene 7a-7c und dem Stromrichtergehäuse 6, was die Durchschlagsfestigkeit erhöht. Zur weiteren Vergrößerung des Abstands ist im Stromrichtergehäuse 6 zudem eine Eintiefung 20 ausgebildet.

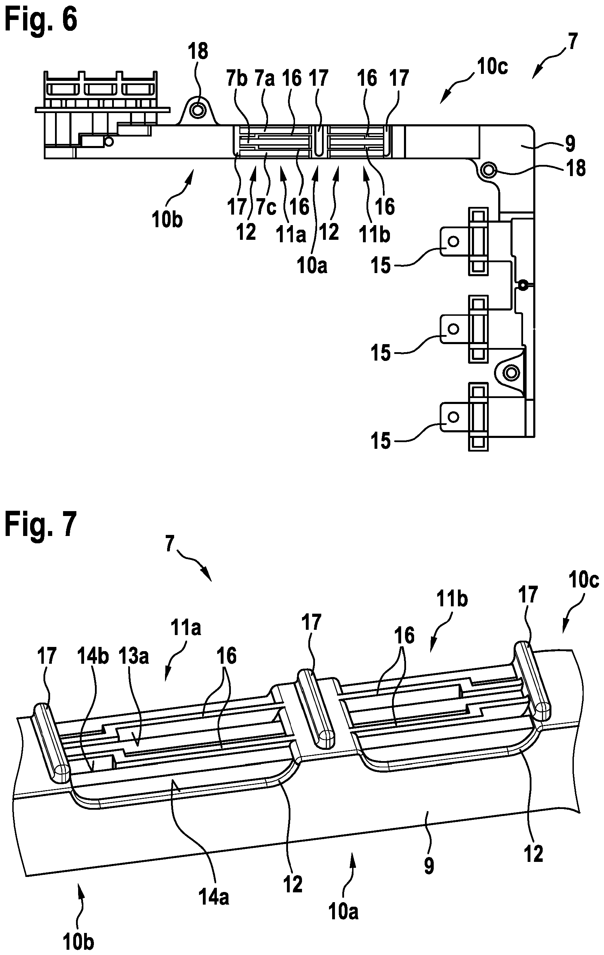

Fig. 6 ist eine Draufsicht auf eine Stromschienenvorrichtung 7 gemäß einem weiteren Ausführungsbeispiel einer Anordnung 5. Dabei sind gegenüber der in den Fig. 2 bis 5 gezeigten Stromschienenvorrichtung 7 gleiche oder gleichwirkende Komponenten mit identischen Bezugszeichen versehen.

Bei dem Ausführungsbeispiel gemäß Fig. 6 verlaufen drei Stromschienen 7a-7c geradlinig durch insgesamt zwei Temperierbereiche 11a, 11b und einen dazwischenliegenden Isolationsbereich 10a, insbesondere ohne dass in den Temperierbereichen 11a, 11b eine Stromschiene zur Ausbildung eines Anschlussabschnitts 15 abzweigt. Außerdem ist in diesem Ausführungsbeispiel keine Eintiefung im Stromrichtergehäuse vorgesehen. Das Wärmeübertragungsmittel ist auf einer ebenen Oberfläche des Stromrichtergehäuses, auf dem auch die Abstandshalter 17 aufliegen, angeordnet.

Fig. 7 ist eine perspektivische Teildarstellung der Temperierbereiche 11a, 11b der Stromschienenvorrichtung 7, in der besonders gut zu erkennen ist, dass die Öffnung 12 an den äußeren Grundflächen 14a, 14b durch einen Ausschnitt aus dem Isolationskörper 9 gebildet ist. Der Ausschnitt erstreckt sich von einem Isolationsbereich 10b bzw. 10a in der Stromflussrichtung zunächst bogenförmig, verläuft dann parallel zur Stromflussrichtung und mündet am Ende eines jeweiligen Temperierbereichs 11a, 11b bogenförmig in den gegenüberliegenden Isolationsbereich 10a bzw. 10c. Dies gilt auch für den in den Fig. 2 und 3 gezeigten Temperierbereich 11a, wohingegen der dort gezeigte Temperierbereich 11b rechtwinklig in den Isolationsbereich 10c übergeht. In Fig. 7 ist ferner der Versprung gut zu erkennen, wobei dieser hier nicht mittig angeordnet ist.

Obwohl die in den vorangegangenen Ausführungsbeispielen beschriebenen Anordnungen 5 jeweils drei Stromschienen 7a-7c zur wechselstromseitigen Kontaktierung der Leistungseinheit 8a aufweisen, können entsprechende Anordnungen mit typischerweise zwei Stromschienen auch zur gleichstromseitigen Kontaktierung der Leistungseinheit 8a ausgebildet sein.

## Patentansprüche

1. Anordnung (5) mit einer Stromschienenvorrichtung (7) und einem Stromrichtergehäuse (6), wobei die Stromschienenvorrichtung einen Stapel aus wenigstens zwei Stromschienen (7a-7c) und einen elektrisch isolierenden Isolationskörper (9), der die Stromschienen (7a-7c) in zwei Isolationsbereichen (10a-10d) der Stromschienenvorrichtung (7) einschließt, aufweist, wobei jede Stromschiene (7a-7c) zwei gegenüberliegende, sich in Stromflussrichtung erstreckende Grundflächen (14a, 14b) und die Grundflächen (14a, 14b) verbindende, sich in Stromflussrichtung erstreckende Seitenflächen (13a, 13b) aufweist,
**dadurch gekennzeichnet,**
**dass** die Stromschienenvorrichtung (7) einen zwischen den Isolationsbereichen (10a-10d) ausgebildeten Temperierbereich (11a-11c) aufweist, in welchem der Isolationskörper (9) eine Öffnung (12) aufweist, die eine der Seitenflächen (13a) und einen Teil zumindest einer der Grundflächen (14a, 14b) einer jeweiligen Stromschiene (7a-7c) freilegt, wobei die Stromschienen (7a-7c) im Temperierbereich (11a-11c) durch ein Wärmeübertragungsmittel (19) thermisch an das Stromrichtergehäuse (6) angebunden sind, wobei das Wärmeübertragungsmittel (19) ein Gapfiller ist, in welchen die Stromschienen (7a-7c) im Temperierbereich (11a-11c) eingetaucht sind, sodass dieser gleichzeitig eine thermische Anbindung und eine elektrische Isolierung zum Stromrichtergehäuse realisiert.

2. Anordnung nach Anspruch 1, wobei der Isolationskörper (9) im Temperierbereich (11a-11c) zwischen jedem Paar benachbarter Stromschienen (7a-7c) einen Vorsprung (16) aufweist, der sich entlang der Grundflächen (14a, 14b) über die freiliegende Seitenfläche (13a) hinaus erstreckt.

3. Anordnung nach Anspruch 1 oder 2, wobei der Isolationskörper (9) im Isolationsbereich (10a-10d) einen Abstandshalter (17) aufweist, der auf dem Stromrichtergehäuse (6) aufliegt und die Stromschienen (7a-7c) im Temperierbereich (11a-11c) vom Stromrichtergehäuse (6) beabstandet.

4. Anordnung nach einem der vorhergehenden Ansprüche, wobei das Stromrichtergehäuse (6) eine das Wärmeübertragungsmittel (19) aufnehmende Eintiefung (20) aufweist.

5. Anordnung nach einem der vorhergehenden Ansprüche, wobei die Stromschienenvorrichtung (7) einen durch einen weiteren Isolationsbereich (10c) vom ersten Isolationsbereich (10a) getrennten weiterer Temperierbereich (11c) aufweist, wobei die Stromschienen (7a-7c) im weiteren Isolationsbereich (10c), insbesondere um 90°, abgewinkelt verlaufen.

6. Anordnung nach einem der vorhergehenden Ansprüche, wobei ein durch einen weiteren Isolationsbereich (10b, 10c, 10d) vom ersten Isolationsbereich (10a) getrennter weiterer Temperierbereich (11b, 11c) vorgesehen ist, wobei der Stapel im weiteren Temperierbereich (11b, 11c) ein weitere Stromschiene (7c) aufweist, die im ersten Temperierbereich (11a) vom Isolationskörper (9) eingefasst ist und/oder nicht durch das Wärmeübertragungsmittel (19) thermisch an das Stromrichtergehäuse (6) angebunden ist.

7. Verfahren zur Herstellung einer Anordnung (5) mit einer Stromschienenvorrichtung (7) und einem Stromrichtergehäuse (6), umfassend folgende Schritte:
- Bereitstellen eines Stromrichtergehäuses (6);
- Aufbringen eines Wärmeübertragungsmittels (19) auf das Stromrichtergehäuse (6), wobei das Wärmeübertragungsmittel (1) ein Gapfiller ist;
- Bereitstellen einer Stromschienenvorrichtung (7), welche einen Stapel aus wenigstens zwei Stromschienen (7a-7c) und einen elektrisch isolierenden Isolationskörper (9), der die Stromschienen (7a-7c) in zwei Isolationsbereichen (10a-10d) der Stromschienenvorrichtung (7) einschließt, aufweist, wobei jede Stromschiene (7a-7c) zwei gegenüberliegende, sich in Stromflussrichtung erstreckende Grundflächen (14a, 14b) und die Grundflächen (14a, 14b) verbindende, sich in Stromflussrichtung erstreckende Seitenflächen (13a, 13b) aufweist, wobei die Stromschienenvorrichtung (7) einen zwischen den Isolationsbereichen (10a-10d) ausgebildeten Temperierbereich (11a-11c) aufweist, in welchem der Isolationskörper eine Öffnung (12) aufweist, die eine der Seitenflächen (13a) und einen Teil zumindest einer der Grundflächen (14a, 14b) einer jeweiligen Stromschiene (7a-7c) freilegt; und
- Einbringen der im Temperierbereich (11a-11c) freiliegenden Stromschienen (7a-7c) in das Wärmeübertragungsmittel (19) durch Eintauchen der Stromschienen (7a-7c) in den Gapfiller, sodass dieser gleichzeitig eine thermische Anbindung und eine elektrische Isolierung zum Stromrichtergehäuse realisiert.

8. Stromrichter (3) für ein Fahrzeug (1), umfassend eine Anordnung (5) nach einem der Ansprüche 1 bis 6 oder erhalten durch ein Verfahren nach Anspruch 7 und eine im Stromrichtergehäuse (6) aufgenommene Leistungseinheit (8a).

9. Fahrzeug (1), umfassend eine elektrische Maschine (2), die zum Antreiben des Fahrzeugs (1) eingerichtet ist, und einen Stromrichter (3) nach Anspruch 8, der zum Bereitstellen eines Wechselstroms für die elektrische Maschine (2) eingerichtet ist.

## Claims

1. An arrangement (5) comprising a busbar device (7) and a converter housing (6), the busbar device comprising a stack of at least two busbars (7a-7c) and an electrically insulating insulation body (9) enclosing the busbars (7a-7c) in two insulation regions (10a-10d) of the busbar device (7), each busbar (7a-7c) having two opposing base surfaces (14a, 14b) extending in the direction of current flow and side surfaces (13a, 13b) connecting the base surfaces (14a, 14b) and extending in the direction of current flow,
**characterized in that**
the busbar device (7) has a tempering region (11a-11 c) formed between the insulation regions (10a-10d), in which tempering region (11a-11c) the insulation body (9) has an opening (12) which exposes one of the side surfaces (13a) and a part of at least one of the base surfaces (14a, 14b) of a respective busbar (7a-7c), the busbars (7a-7c) being thermally connected to the converter housing (6) in the temperature control region (11a-11c) by a heat transfer means (19), the heat transfer means (19) being a gap filler in which the busbars (7a-7c) are immersed in the temperature control region (11a-11c), so that this gap filler simultaneously implements a thermal connection and an electrical insulation to the converter housing.

2. Arrangement according to claim 1, wherein the insulation body (9) has a protrusion (16) in the tempering region (11a-11c) between each pair of adjacent busbars (7a-7c), the protrusion (16) extending along the base surfaces (14a, 14b) beyond the exposed side surface (13a).

3. Arrangement according to claim 1 or 2, wherein the insulation body (9) has a spacer (17) in the insulation region (10a-10d), which spacer (17) rests on the converter housing (6) and spaces the busbars (7a-7c) in the temperature control region (11a-11c) from the converter housing (6).

4. Arrangement according to any one of the preceding claims, wherein the converter housing (6) comprises a recess (20) receiving the heat transfer means (19).

5. Arrangement according to any one of the preceding claims, wherein the busbar device (7) has a further tempering region (11c) separated from the first insulation region (10a) by a further insulation region (10c), wherein the busbars (7a-7c) in the further insulation region (100) run at an angle, in particular 90°.

6. Arrangement according to any one of the preceding claims, wherein a further temperature control region (11b, 11c) separated from the first temperature control region (10a) by a further insulation region (10b, 10c, 10d) is provided, wherein the stack has in the further temperature control region (11b, 11c) a further busbar (7c) which is enclosed in the first temperature control region (11a) by the insulation body (9) and/or is not thermally connected to the converter housing (6) by the heat transfer means (19).

7. A method of manufacturing an assembly (5) comprising a busbar device (7) and a converter housing (6), comprising the following steps:
- providing a power converter housing (6);
- applying a heat transfer agent (19) to the converter housing (6), wherein the heat transfer agent (1) is a gap filler;
- providing a busbar device (7) comprising a stack of at least two busbars (7a-7c) and an electrically insulating insulating body (9) enclosing the busbars (7a-7c) in two insulating regions (10a-10d) of the busbar device (7), each busbar (7a-7c) having two opposite base surfaces (14a, 14b) extending in the direction of current flow and side surfaces (13a, 13b) connecting the base surfaces (14a, 14b), each busbar (7a-7c) having two opposite base surfaces (14a, 14b) extending in the direction of flow of current and side surfaces (13a, 13b) connecting the base surfaces (14a, 14b) and extending in the direction of flow of current, the busbar device (7) having a tempering portion (11a-11c) formed between the insulation portions (10a-10d), in which the insulation body has an opening (12) exposing one of the side surfaces (13a) and a part of at least one of the base surfaces (14a, 14b) of a respective busbar (7a-7c); and
- Insertion of the busbars (7a-7c), which are exposed in the tempering region (11a-11c), into the heat transfer medium (19) by dipping the busbars (7a-7c) into the gaptiller, so that the latter simultaneously realizes a thermal connection and an electrical insulation to the converter housing.

8. A converter (3) for a vehicle (1), comprising an arrangement (5) according to any one of claims 1 to 6 or obtained by a method according to claim 7 and a power unit (8a) housed in the converter housing (6).

9. A vehicle (1) comprising an electric machine (2) adapted to drive the vehicle (1), and a power converter (3) according to claim 8 adapted to provide an alternating current to the electric machine (2).

## Revendications

1. Agencement (5) comportant un dispositif de barres conductrices (7) et un boîtier de convertisseur (6), en ce que le dispositif de barres conductrices comporte une pile d'au moins deux barres conductrices (7a-7c) et un corps d'isolation électriquement isolant (9) qui inclut les barres conductrices (7a-7c) dans deux zones d'isolation (10a-10d) du dispositif de barres conductrices (7), en ce que chaque barre conductrice (7a-7c) comporte deux surfaces de base (14a, 14b) opposées, s'étendant dans le sens de conduction de courant et les faces latérales (13a, 13b) reliant des surfaces de base (14a, 14b) s'étendant dans le sens de conduction de courant,
**caractérisé en ce que**
le dispositif de barres conductrices (7) comporte une zone de régulation de température (11a-11c) réalisée entre les zones d'isolation (10a-10d), dans laquelle le corps d'isolation (9) comporte une ouverture (12) qui dégage l'une des faces latérales (13a) et une partie d'au moins l'une des surfaces de base (14a, 14b) d'une barre conductrice (7a-7c) respective, **en ce que** les barres conductrices (7a-7c) sont raccordées thermiquement au boîtier de convertisseur (6) dans la zone de régulation de température (11a-11c) par un fluide caloporteur (19), **en ce que** le fluide caloporteur (19) est un agent de remplissage d'écart, dans lequel les barres conductrices (7a-7c) sont immergées dans la zone de régulation de température(11a-11c) de sorte que celui-ci réalise simultanément une liaison thermique et une isolation électrique au boîtier de convertisseur.

2. Agencement selon la revendication 1, en ce que le corps d'isolation (9) comporte dans la zone de régulation de température (11a-11c) entre chaque paire de barres conductrices (7a-7c) adjacentes une partie en saillie (16) qui s'étend le long des surfaces de base (14a, 14b) au-delà de la face latérale (13a) dégagée.

3. Agencement selon la revendication 1 ou 2, en ce que le corps d'isolation (9) comporte une entretoise (17) dans la zone d'isolation (10a-10d) qui repose sur le boîtier de convertisseur (6) et espace les barres conductrices (7a-7c) du boîtier de convertisseur (6) dans la zone de régulation de température (11a-11c).

4. Agencement selon l'une des revendications précédentes, en ce que le boîtier de convertisseur (6) comporte une cavité (20) recevant le fluide caloporteur (19).

5. Agencement selon l'une des revendications précédentes, en ce que le dispositif de barres conductrices (7) comporte une autre zone de régulation de température (11c) séparée par une autre zone d'isolation (10c) de la première zone d'isolation (10a), en ce que les barres conductrices (7a-7c) sont coudées dans l'autre zone d'isolation (10c), en particulier à 90°.

6. Agencement selon l'une des revendications précédentes, en ce qu'une autre zone de régulation de température (11b, 11c) séparée par une autre zone d'isolation (10b, 10c, 10d) de la première zone d'isolation (10a) est prévue, en ce que la pile dans l'autre zone de régulation de température (11b, 11c) comporte une autre barre conductrice (7c) qui est entourée dans la première zone de régulation de température (11a) par le corps d'isolation (9) et/ou qui n'est pas reliée thermiquement par le fluide caloporteur (19) au boîtier de convertisseur (6).

7. Procédé de fabrication d'un agencement (5) avec un dispositif de barres conductrices (7) et un boîtier de convertisseur (6), comprenant les étapes suivantes consistant à :
- mettre à disposition un boîtier de convertisseur (6) ;
- appliquer un fluide caloporteur (19) sur le boîtier de convertisseur (6), en ce que le fluide caloporteur (1) est un agent de remplissage d'écart ;
- mettre à disposition un dispositif de barres conductrices (7) qui comporte une pile d'au moins deux barres conductrices (7a-7c) et un corps d'isolation (9) électriquement isolant qui inclut les barres conductrices (7a-7c) dans deux zones d'isolation (10a-10d) du dispositif de barres conductrices (7), en ce que chaque barre conductrice (7a-7c) comporte deux surfaces de base (14a, 14b) opposées, s'étendant dans le sens de conduction de courant et les faces latérales (13a, 13b) reliant des surfaces de base (14a, 14b) s'étendant dans le sens de conduction de courant, en ce que le dispositif de barres conductrices (7) comporte une zone de régulation de température (11a-11c) réalisée entre les zones d'isolation (10a-10d), dans laquelle le corps d'isolation comporte une ouverture (12) qui dégage l'une des faces latérales (13a) et une partie d'au moins l'une des surfaces de base (14a, 14b) d'une barre conductrice (7a-7c) respective ;
- introduire les barres conductrices (7a-7c) dégagées dans la zone de régulation de température (11a-11c) dans le fluide caloporteur(19) par immersion des barres conductrices (7a-7c) dans l'agent de remplissage d'écart de sorte que celui-ci réalise simultanément une liaison thermique et une isolation électrique au boîtier de convertisseur.

8. Convertisseur (3) pour un véhicule (1), comprenant un agencement (5) selon l'une des revendications 1 à 6 ou obtenu par un procédé selon la revendication 7 et une unité de puissance (8a) intégrée dans le boîtier de convertisseur (6).

9. Véhicule (1) comprenant une machine électrique (2) qui est configurée pour l'entraînement du véhicule (1), et un convertisseur (3) selon la revendication 8 qui est configuré pour fournir un courant alternatif à la machine électrique (2).
